# EUROPEAN PATENT APPLICATION

(11) **EP 4 815 304 A1**
(43) Date of publication of application: **30.09.2026**
(21) Application number: 26165353.9
(22) Date of filing: 17.03.2026
(51) Int. Cl.: H03K 3/356, H03K 5/1534, H03K 5/151

(54) **LEVEL SHIFT CIRCUIT AND LEVEL SHIFTER**

(30) Priority: 25.03.2025 JP 2025050176; 23.12.2025 JP 2025278131
(71) Applicant: ABLIC Inc., Kitasaku-gun, Nagano 389-0293 (JP)
(72) Inventor: IMAIZUMI, Eiki, Kitasaku-gun, Nagano, 389-0293 (JP)
(74) Representative: Winter, Brandl - Partnerschaft mbB

(57) **Abstract**

In order to enable generating an output logic signal having a duty cycle substantially equal to a duty cycle of an input logic signal, provided is a level shift circuit including a first transistor, a second transistor, a third transistor, a fourth transistor, a clamp circuit for limiting voltages of a first node and a second node within a range from a third voltage to a fourth voltage, and a waveform shaping circuit for providing an output logic signal based on level transitions of an input first logic signal and an input second logic signal in the same direction.

## Description

### BACKGROUND

### 1. Field

The present invention relates to a level shift circuit and a level shifter.

### 2. Description of the Related Art

Hitherto, there has been known a logic level circuit for converting a logic level of a low-voltage region into a logic level of a high-voltage region by switching a transistor or the like according to an input signal (see, for example, Japanese Patent Application Laid-open No. 2021-52393).

In a case of a related-art level shift circuit, a duty cycle of an output logic signal significantly deviates from a duty cycle of an input logic signal because of a response time required for raising a voltage of a logic level of a low-voltage region to a logic level of a high-voltage region. Transmission of the logic signal over a plurality of stages each using such a level shift circuit causes an increase in deviation of the duty cycle every time the number of transmission stages increases. A pulse may disappear in a worst case.

Accordingly, the present invention has an object to provide a technology capable of generating an output logic signal having a duty cycle substantially equal to a duty cycle of an input logic signal.

### SUMMARY

According to at least one aspect of the present invention, there is provided a level shift circuit for shifting a level of an input logic signal indicating logic levels with a first voltage and a second voltage into an output logic signal indicating logic levels with a third voltage and a fourth voltage, the level shift circuit including: a first transistor including a gate supplied with a reverse-phase signal of the input logic signal, a source connected to the first voltage, and a drain connected to a clamp circuit; a second transistor including a gate supplied with a positive-phase signal of the input logic signal, a source connected to the first voltage, and a drain connected to the clamp circuit; a third transistor including a source connected to the fourth voltage and a drain connected to the clamp circuit; a fourth transistor including a source connected to the fourth voltage and a drain connected to the clamp circuit; the clamp circuit connected to a first node and a second node and configured to limit voltages of the first node and the second node within a range from the third voltage to the fourth voltage; a first buffer circuit configured to receive the voltage of the first node and provide a first logic signal corresponding to the voltage of the first node; a second buffer circuit configured to receive the voltage of the second node and provide a second logic signal corresponding to the voltage of the second node; and a waveform shaping circuit configured to receive the first logic signal and the second logic signal and provide the output logic signal based on level transitions of the first logic signal and the second logic signal in the same direction, in which, of a pair of the first transistor and the second transistor and a pair of the third transistor and the fourth transistor, the pair connected to a high-voltage side are of a first conductivity type being one of a P-type or an N-type, and the pair connected to a low-voltage side are of a second conductivity type being another one of the P-type or the N-type.

Further, according to at least one aspect of the present invention, there is also provided a level shifter including a plurality of stages each including the above-mentioned level shift circuit, the stages being connected in series.

According to the at least one aspect of the present invention, it is possible to generate the output logic signal having the duty cycle substantially equal to the duty cycle of the input logic signal.

### BRIEF DESCRIPTION OF THE DRAWINGS

FIG. 1 is a schematic diagram for illustrating a circuit configuration example of a level shift circuit according to a first embodiment of the present invention.
FIG. 2 is a schematic diagram for illustrating a configuration example of a waveform shaping circuit in the level shift circuit according to the first embodiment.
FIG. 3 is a timing chart for illustrating an example of voltage changes at respective positions in the level shift circuit according to the first embodiment.
FIG. 4 is a schematic diagram for illustrating a configuration example of a level shifter according to the first embodiment.
FIG. 5 is a schematic diagram for illustrating a circuit configuration example of a level shift circuit according to a modification example.
FIG. 6 is a schematic diagram for illustrating a configuration example of a waveform shaping circuit in the level shift circuit according to the modification example.
FIG. 7 is a timing chart for illustrating an example of voltage changes at respective positions in the level shift circuit according to the modification example.
FIG. 8 is a schematic diagram for illustrating a circuit configuration example of a level shift circuit according to a second embodiment of the present invention.
FIG. 9 is a timing chart for illustrating an example of voltage changes at respective positions in the level shift circuit according to the second embodiment.

### DESCRIPTION OF THE EMBODIMENTS

A level shift circuit and a level shifter according to at least one embodiment of the present invention are described in detail below by means of at least one preferred embodiment with reference to the attached drawings. In the description of the drawings, the same or similar parts are denoted by the same or similar reference symbols.

Throughout the drawings for illustrating the at least one embodiment, components having the same function are denoted by the same reference symbols, and a duplicate description thereof is omitted. The description "based on XX" as used herein means "based on at least XX," and encompasses a case of being "based on another element in addition to XX." Further, the description "based on XX" is not limited to a case of directly using "XX" but encompasses a case of being "based on a result of calculating or processing XX." The term "XX" refers to a freely selected element (for example, freely selected information).

In the at least one embodiment, transistors having higher breakdown voltages than those of general MOS transistors such as double-diffused MOS transistors are partially used. To distinguish from general MOS transistors, a general N-type MOS transistor is referred to as "transistor MNx," and a general P-type MOS transistor is referred to as "transistor MPx." In addition, of transistors having higher breakdown voltages than those of general MOS transistors, an N-type transistor is referred to as "transistor MDNx," and a P-type transistor is referred to as "transistor MDPx."

A level shift circuit according to the at least one embodiment is a level shift circuit for shifting a logic level from a first voltage region (a logic level on a low-voltage side or a high-voltage side) to a second voltage region (a logic level on a high-voltage side or a low-voltage side). Here, two voltage levels of "low" and "high" in the first voltage region before level shifting are referred to as "first voltage" and "second voltage." Two voltage levels of "low" and "high" in the second voltage region after level shifting are referred to as "third voltage" and "fourth voltage." In addition, of the first voltage and the second voltage, one closer in voltage level to the second voltage region is referred to as "second voltage," and another one is referred to as "first voltage." Further, of the third voltage and the fourth voltage, one closer in voltage level to the first voltage region is referred to as "third voltage," and another one is referred to as "fourth voltage." Each embodiment is described below.

### [First Embodiment]

A level shift circuit according to a first embodiment of the present invention is a level shift circuit for shifting a logic level from a low-voltage region (a logic level on a low-voltage side) to a high-voltage region (a logic level on a high-voltage side). In addition, a level shifter according to the first embodiment includes a plurality of stages each including the level shift circuit according to the first embodiment, the plurality of stages being connected in series.

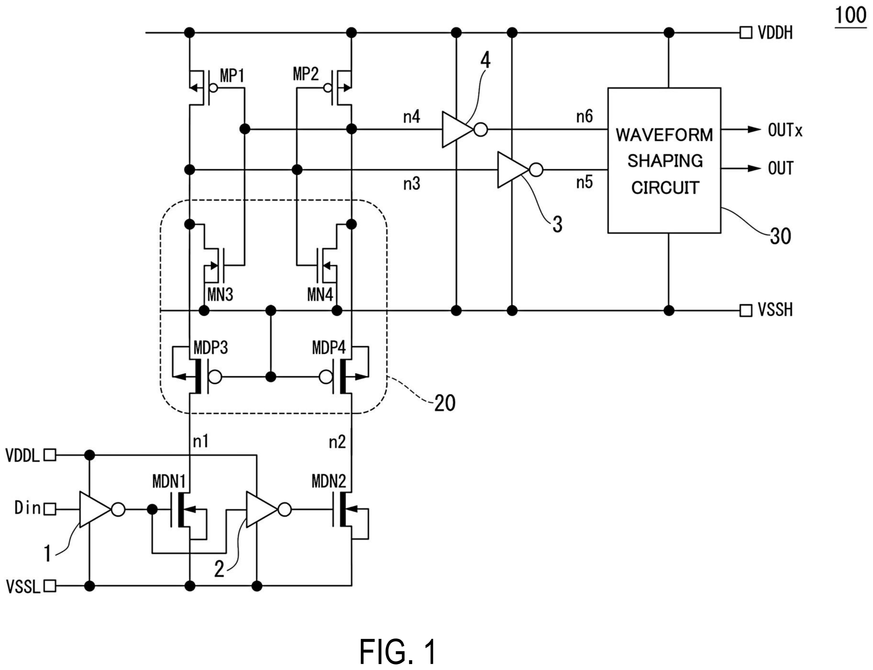

FIG. 1 is a schematic diagram for illustrating a circuit configuration example of a level shift circuit 100 being an example of the level shift circuit according to the first embodiment.

In the level shift circuit 100, at the logic level on the low-voltage side, a "low" level voltage is set as a voltage VSSL serving as the first voltage, and a "high" level voltage is set as a voltage VDDL serving as the second voltage. At the logic level on the high-voltage side, a "low" level voltage is set as a voltage VSSH serving as the third voltage, and a "high" level voltage is set as a voltage VDDH serving as the fourth voltage.

The level shift circuit 100 illustrated in FIG. 1 provides an output logic signal OUT of a logic level from the voltage VSSH to the voltage VDDH based on an input logic signal Din of a logic level from the voltage VSSL to the voltage VDDL. The level shift circuit 100 includes an inverter circuit 1, an inverter circuit 2, an inverter circuit 3, an inverter circuit 4, a transistor MDN1, a transistor MDN2, a transistor MP1, a transistor MP2, a clamp circuit 20, and a waveform shaping circuit 30.

The input logic signal Din is supplied to an input terminal of the inverter circuit 1. An output terminal of the inverter circuit 1 is connected to a gate of the transistor MDN1 and the inverter circuit 2. An input terminal of the inverter circuit 2 is connected to the output terminal of the inverter circuit 1. An output terminal of the inverter circuit 2 is connected to a gate of the transistor MDN2.

The transistor MDN1 serving as a first transistor has the gate connected to the output terminal of the inverter circuit 1, a source connected to the voltage VSSL, and a drain connected to the clamp circuit 20. The input logic signal Din having a reverse phase after passage through the inverter circuit 1 is supplied to the gate of the transistor MDN1. The drain of the transistor MDN1 is connected to a drain of the transistor MP1 through the clamp circuit 20.

The transistor MDN2 serving as a second transistor has the gate connected to the output terminal of the inverter circuit 2, a source connected to the voltage VSSL, and a drain connected to the clamp circuit 20. The input logic signal Din having a positive phase after passage through the inverter circuit 1 and the inverter circuit 2 is supplied to the gate of the transistor MDN2. The drain of the transistor MDN2 is connected to a drain of the transistor MP2 through the clamp circuit 20.

In the following description, a connection between the drain of the transistor MDN1 and the clamp circuit 20 is sometimes referred to as "node n1." A connection between the drain of the transistor MDN2 and the clamp circuit 20 is sometimes referred to as "node n2."

The transistor MP1 serving as a third transistor has a gate and the drain connected to the clamp circuit 20, and a source connected to the voltage VDDH. Similarly to the transistor MP1, the transistor MP2 serving as a fourth transistor has a gate and the drain connected to the clamp circuit 20, and a source connected to the voltage VDDH.

The clamp circuit 20 is connected to the drains of the transistor MDN1 and the transistor MDN2 on a low-voltage side. The clamp circuit 20 is also connected to the drains and the gates of the transistor MP1 and the transistor MP2 on a high-voltage side. In the description of the first embodiment, a connection between the gate of the transistor MP2 and the clamp circuit 20 is sometimes referred to as "node n3." Further, a connection between the transistor MP1 and the clamp circuit 20 is sometimes referred to as "node n4." The node n3 and the node n4 are output terminals of the clamp circuit 20, and are not limited to a case of connections to the gates.

The drains of the transistor MDN1 and the transistor MP1 are connected to each other through the clamp circuit 20. Accordingly, in a case in which the transistor MP1 is off and the transistor MDN1 is on, a voltage on the gate side of the transistor MP1 is pulled toward the voltage VSSL to which the source of the transistor MDN1 is connected. Meanwhile, in a case in which the transistor MDN1 is off and the transistor MP1 is on, a voltage on the gate side of the transistor MP1 is pulled toward the voltage VDDH to which the source of the transistor MP1 is connected. The transistor MDN2 and the transistor MP2 also have a relationship similar to the relationship between the transistor MDN1 and the transistor MP1.

The clamp circuit 20 is connected to the node n3 and the node n4. The clamp circuit 20 limits voltages of the node n3 and the node n4 to stay within a range from the voltage VSSH to the voltage VDDH serving as the high-voltage region. In other words, the clamp circuit 20 prevents the voltages of the node n3 and the node n4 from becoming smaller than the voltage VSSH at the "low" level in the high-voltage region.

The clamp circuit 20 also controls on/off states of the transistor MP1 and the transistor MP2 by supplying gate signals thereto in accordance with on/off states of the transistor MDN1 and the transistor MDN2.

An input terminal of the inverter circuit 3 is connected to the node n3 serving as the first node. An output terminal of the inverter circuit 3 is connected to the waveform shaping circuit 30. Further, an input terminal of the inverter circuit 4 is connected to the node n4 serving as the second node. An output terminal of the inverter circuit 4 is connected to the waveform shaping circuit 30. That is, a first logic signal corresponding to a voltage value of the node n3 and a second logic signal corresponding to a voltage value of the node n4 are supplied to the waveform shaping circuit 30. In the following description, a connection between the output terminal of the inverter circuit 3 and the waveform shaping circuit 30 is referred to as "node n5." The first logic signal is sometimes denoted by a reference symbol "n5." Further, a connection between the output terminal of the inverter circuit 4 and the waveform shaping circuit 30 is referred to as "node n6." The second logic signal is sometimes denoted by a reference symbol "n6."

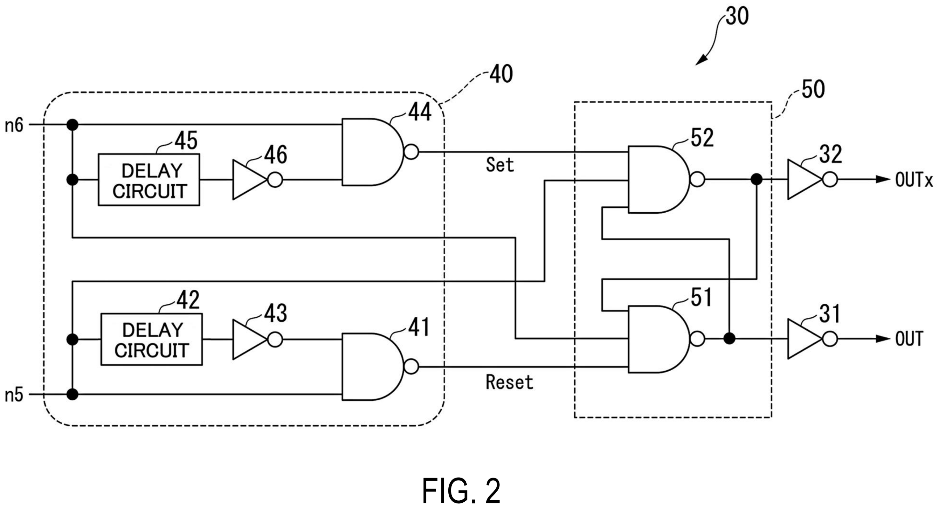

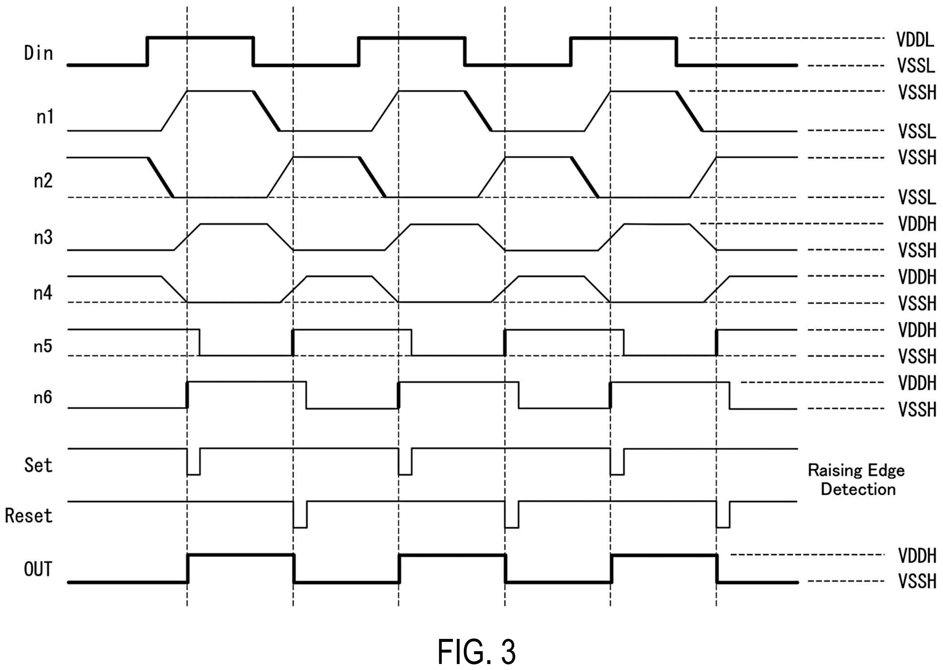

The waveform shaping circuit 30 shapes a waveform by inverting a logic level based on level transitions in the same direction (from "low" to "high" in FIG. 1) of the supplied first logic signal n5 and the supplied second logic signal n6. The waveform shaping circuit 30 maintains a latch while an event for inverting the logic level based on the first logic signal n5 and the second logic signal n6 does not occur. The level shift circuit 100 can cause a duty cycle of the output logic signal OUT to be substantially equal to a duty cycle of the input logic signal Din by inverting the logic level based on the first logic signal n5 and the second logic signal n6. See FIG. 2 and FIG. 3 for more details. An output logic signal OUTx is an inverted signal of the output logic signal OUT.

The clamp circuit 20 is described next.

The clamp circuit 20 includes a transistor MDP3, a transistor MDP4, a transistor MN3, and a transistor MN4. The node n3 is connected to the drain of the transistor MP1. The node n4 is connected to the drain of the transistor MP2. The circuit configuration of the clamp circuit 20 illustrated in FIG. 1 is an example of implementation of the clamp circuit 20. The first embodiment is not limited to this example.

The transistor MDP3 serving as a fifth transistor has a gate supplied with the voltage VSSH, a source connected to the node n3, and a drain connected to the node n1. Further, the transistor MDP4 serving as a sixth transistor has a gate supplied with the voltage VSSH, a source connected to the node n4, and a drain connected to the node n2. The transistor MDP3, by having the gate supplied with the voltage VSSH at the "low" level in the high-voltage region, is turned off in a case in which a source voltage (node n3) is about to fall below the voltage VSSH, and thereby cuts off a connection to the voltage VSSL through the transistor MDN1. As a result, the node n3 is prevented from further falling in voltage, and is thereby clamped within the range of the high-voltage region. The transistor MDP4 also functions similarly to the transistor MDP3 in clamping the node n4.

The transistor MN3 serving as a seventh transistor has a gate connected to the node n4, a source connected to the voltage VSSH, and a drain connected to the node n3. Further, the transistor MN4 serving as an eighth transistor has a gate connected to the node n3, a source connected to the voltage VSSH, and a drain connected to the node n4. The node n3 can stably provide the "low" level (voltage VSSH) in the high-voltage region by the transistor MN3 being turned on to connect the voltage VSSH and the node n3 in a case of providing the "low" level from the node n3. The transistor MN4 also functions similarly to the transistor MN3 in a case of providing the "low" level from the node n4.

FIG. 2 is a schematic diagram for illustrating a configuration example of the waveform shaping circuit 30 in the first embodiment.

The waveform shaping circuit 30 includes an edge detection circuit 40, a latch circuit 50, an inverter circuit 31, and an inverter circuit 32.

The first logic signal n5 and the second logic signal n6 are supplied to the edge detection circuit 40. The first logic signal n5 and the second logic signal n6 are supplied to the latch circuit 50 through the edge detection circuit 40. The inverter circuit 31 inverts a logic level of the output logic signal OUT provided from the latch circuit 50. The inverter circuit 32 inverts a logic level of the output logic signal OUTx provided from the latch circuit 50.

Examples of functions and configurations of the edge detection circuit 40 and the latch circuit 50 are described next. The configurations of the waveform shaping circuit 30, the edge detection circuit 40, and the latch circuit 50 illustrated as examples in FIG. 2 are merely examples of implementation. The first embodiment is not limited to those examples.

The edge detection circuit 40 detects a rising edge or a falling edge of the first logic signal n5. The edge detection circuit 40 transmits a detection result of whether the rising edge or the falling edge of the first logic signal n5 has been detected by providing a Reset signal to the latch circuit 50. The edge detection circuit 40 also detects a rising edge or a falling edge of the second logic signal n6. The edge detection circuit 40 transmits a detection result of whether the rising edge or the falling edge of the second logic signal n6 has been detected by providing a Set signal to the latch circuit 50. In this case, detection of a rising edge or a falling edge is performed in a common manner for the first logic signal n5 and the second logic signal n6. Specifically, an example of detecting a rising edge in signals supplied to the edge detection circuit 40 is described.

The edge detection circuit 40 includes a NAND circuit 41, a delay circuit 42, an inverter circuit 43, a NAND circuit 44, a delay circuit 45, and an inverter circuit 46. In the edge detection circuit 40, the NAND circuit 41, the delay circuit 42, and the inverter circuit 43 constitute a first edge detection circuit for detecting the rising edge of the first logic signal n5 and providing a first detection signal. The NAND circuit 44, the delay circuit 45, and the inverter circuit 46 constitute a second edge detection circuit for detecting the rising edge of the second logic signal n6 and providing a second detection signal.

The first logic signal n5 is directly supplied to a first input terminal of the NAND circuit 41. Meanwhile, a delayed and inverted first logic signal n5 after passage through the delay circuit 42 and the inverter circuit 43 is supplied to a second input terminal of the NAND circuit 41. An output terminal of the NAND circuit 41 provides a Reset signal indicating a logic result corresponding to logic levels supplied to the first input terminal and the second input terminal. The NAND circuit 41 provides a Reset signal at a "low" level in a case in which logic levels of the logic signals supplied to both input terminals are at a "high" level. A Reset signal at a "high" level is provided in other cases.

During rising of the first logic signal n5, a "high" level that has risen is supplied to the first input terminal of the NAND circuit 41. Meanwhile, a "high" level obtained by inverting, by the inverter circuit 43, a "low" level present before the rising due to a delay caused by the delay circuit 42 is supplied to the second input terminal of the NAND circuit 41. A Reset signal at a "low" level is provided from the output terminal of the NAND circuit 41.

During falling of the first logic signal n5, a "low" level that has fallen is supplied to the first input terminal of the NAND circuit 41. Meanwhile, a "low" level obtained by inverting, by the inverter circuit 43, a "high" level present before the falling due to a delay caused by the delay circuit 42 is supplied to the second input terminal of the NAND circuit 41. A Reset signal at a "high" level is provided from the output terminal of the NAND circuit 41.

The logic level of the signal supplied to the second input terminal of the NAND circuit 41 is an inversion of the logic level of the signal supplied to the first input terminal of the NAND circuit 41 in a case in which the first logic signal n5 does not change. A Reset signal at a "high" level is provided from the output terminal of the NAND circuit 41.

Accordingly, the NAND circuit 41, the delay circuit 42, and the inverter circuit 43 cause the Reset signal to become the "low" level for an extremely short time from the rising of the first logic signal n5, and enable detection of a rising edge thereof. Detection of the rising edge of the second logic signal n6 by the NAND circuit 44, the delay circuit 45, and the inverter circuit 46 is performed similarly to the detection of the rising edge of the first logic signal n5. A Set signal indicating a detection result is provided from an output terminal of the NAND circuit 44.

The latch circuit 50 includes a NAND circuit 51 serving as a first logic circuit and a NAND circuit 52 serving as a second logic circuit. The NAND circuit 51 includes a first input terminal supplied with the Reset signal, a second input terminal supplied with an output signal of the NAND circuit 52, a third input terminal supplied with the second logic signal n6, and an output terminal providing a logic result. The NAND circuit 52 includes a first input terminal supplied with the Set signal, a second input terminal supplied with an output signal of the NAND circuit 51, a third input terminal supplied with the first logic signal n5, and an output terminal providing a logic result.

Operations of the NAND circuit 51 and the NAND circuit 52 are described with the third input terminals of the NAND circuit 51 and the NAND circuit 52 omitted for simplification. With the third input terminals omitted, the NAND circuit 51 and the NAND circuit 52 constitute a general RS latch circuit. An output result varies depending on the logic levels of the Reset signal and the Set signal.

In a case in which the Reset signal is at the "low" level and the Set signal is at the "high" level, the output terminal of the NAND circuit 51 provides a "low" level and the output terminal of the NAND circuit 52 provides a "high" level. In a case in which the Reset signal is at the "high" level and the Set signal is at the "low" level, the output terminal of the NAND circuit 51 provides a "high" level and the output terminal of the NAND circuit 52 provides a "low" level. In a case in which the Reset signal and the Set signal are at the "high" level, the NAND circuit 51 and the NAND circuit 52 hold logic levels provided immediately before. In a case in which the Reset signal and the Set signal are at the "low" level, logic levels of output signals provided from output terminals of the NAND circuit 51 and the NAND circuit 52 become indeterminate.

In FIG. 2, the Reset signal and the Set signal stay at the "low" level for a short time after detection of a rising edge. The signals stay at the "high" level during a time of no detection. In addition, the logic levels do not become indeterminate because the first logic signal n5 and the second logic signal n6 do not rise simultaneously during operation of the level shift circuit 100. Accordingly, in a case of detection of the rising edge of the first logic signal n5, the output terminal of the NAND circuit 51 provides an output signal at a "low" level and the output terminal of the NAND circuit 52 provides an output signal at a "high" level. Those logic levels are held. Meanwhile, in a case of detection of the rising edge of the second logic signal n6, the output terminal of the NAND circuit 51 provides an output signal at a "high" level and the output terminal of the NAND circuit 52 provides an output signal at a "low" level. Those logic levels are held. This enables the waveform shaping circuit 30 to provide the output logic signal OUT (output logic signal OUTx) having a duty cycle substantially equal to the duty cycle of the input logic signal Din.

The NAND circuit 51 and the NAND circuit 52 further include the third input terminals for bypassing the second logic signal n6 and the first logic signal n5. This prevents the logic result of the latch circuit 50 from becoming indeterminate immediately after starting operation of the level shift circuit 100.

FIG. 3 is a timing chart for illustrating an example of voltage changes at respective positions in the level shift circuit 100. An operation of the level shift circuit 100 is described by appropriately referring to FIG. 1 as well.

In a case in which the input logic signal Din rises, the transistor MDN1 having a gate receiving a reverse-phase signal is turned off, and the transistor MDN2 having a gate receiving a positive-phase signal is turned on. The node n2 is connected to the voltage VSSL at the "low" level in the low-voltage region and a voltage value falls by the transistor MDN2 being turned on. In contrast, even in a case in which the transistor MDN1 is turned on, the voltage value of the node n1 does not rise because the transistor MP1 connected to the voltage VDDH at the "high" level in the high-voltage region is off. The node n1 is connected to the voltage VDDH and the voltage value starts to rise because a voltage value of a gate input of the transistor MP1 falls following the falling in the voltage value of the node n2 and the transistor MP1 is turned on.

The voltage value of the node n4 falls following the falling in the voltage value of the node n2 and is clamped at the voltage VSSH by the clamp circuit 20. The voltage value of the node n3 rises to the voltage VDDH because the transistor MP1 becomes connected to the voltage VDDH. The voltage value of the node n4 stays at the voltage VSSH without rising because the voltage value of the node n3 rises and the transistor MP2 is thereby turned off. The voltage value of the node n3 also stays at the voltage VDDH without falling because the transistor MDN1 is off.

The voltage of the node n3 is an analog signal and is converted into the first logic signal n5 by the inverter circuit 3. The voltage of the node n4 is converted into the second logic signal n6 by the inverter circuit 4.

In a case in which the input logic signal Din falls, operations at the node n1 and the node n2, operations at the node n3 and the node n4, and operations at the node n5 and the node n6 are respectively inverted relative to the operations in the above-mentioned case in which the input logic signal Din rises.

A response time required for raising a voltage of a logic level of a low-voltage region to a logic level of a high-voltage region is different from a response time required for lowering a voltage of a logic level of a high-voltage region to a logic level of a low-voltage region. A duty cycle of the input logic signal Din and duty cycles of voltages of the node n5 and the node n6 are different because of the above-mentioned difference in response time.

A time from the rising of the input logic signal Din to the rising of the voltage of the node n6 and a time from the falling of the input logic signal Din to the rising of the voltage of the node n5 are substantially identical because the respective circuits in the level shift circuit 100 operate symmetrically during rising and falling of the input logic signal Din. A period of a voltage change of the node n5 and a period of a voltage change of the node n6 are also substantially identical. Further, the period of the node n5 and the period of the node n6 are shifted in phase by an amount corresponding to a rising time of the input logic signal Din.

Accordingly, the duty cycle of the input logic signal Din can be reproduced by shaping a waveform through control of rising and falling of the output logic signal OUT based on the same waveform position for the voltage of the node n5 and the voltage of the node n6. The same waveform position is desired to represent a position facilitating identification of, for example, the rising edges or the falling edges of the node n5 and the node n6. The edge detection circuit 40 described above causes a logic level of the output logic signal OUT to transition in a case in which the rising edge of the first logic signal n5 has been detected and a case in which the rising edge of the second logic signal n6 has been detected. The logic level is held during a time of no detection.

The level shift circuit 100 for shifting a logic level from a logic level of a low-voltage region to a logic level of a high-voltage region has been described above. A plurality of stages each including the level shift circuit 100 described above may be connected in series as required. The plurality of stages of level shift circuits 100 connected in series are sometimes collectively referred to as "level shifter 110." The level shift circuit 100 and the level shifter 110 are provided as, for example, an integrated circuit (IC) or a component thereof.

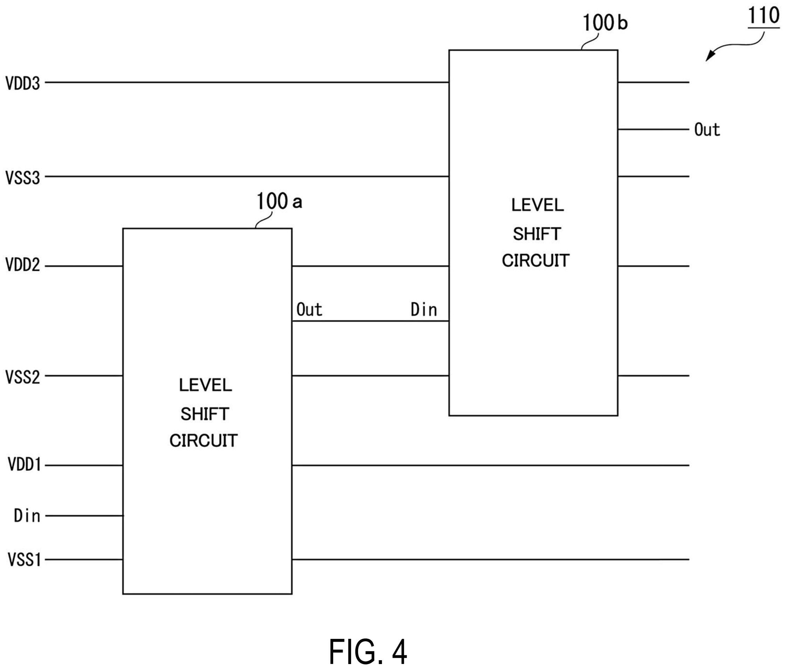

FIG. 4 is a schematic diagram for illustrating a configuration example of the level shifter 110 according to the first embodiment. The level shifter 110 includes a plurality of level shift circuits 100 connected in series through input terminals and output terminals. As an example of the plurality of stages, the level shifter 110 illustrated as an example in FIG. 4 has a two-stage configuration including a first-stage level shift circuit 100a and a second-stage level shift circuit 100b connected in series to a subsequent stage (output terminal side) of the first-stage level shift circuit 100a.

The first-stage level shift circuit 100a provides the output logic signal OUT level-shifted from the first voltage region (a voltage VSS1 to a voltage VDD1) to the second voltage region (a voltage VSS2 to a voltage VDD2). The second-stage level shift circuit 100b provides the output logic signal OUT by shifting the level of the output logic signal OUT of the first-stage level shift circuit 100a from the second voltage region (the voltage VSS2 to the voltage VDD2) to a third voltage region (a voltage VSS3 to a voltage VDD3). The first-stage level shift circuit 100a and the second-stage level shift circuit 100b for shifting a logic level of a signal provided from the first-stage level shift circuit 100a from the second voltage region to the third voltage region are illustrated. In the level shifter 110, the number of the level shift circuits 100 connected in series may be three or more.

A modification example of the level shift circuit according to the first embodiment is described next.

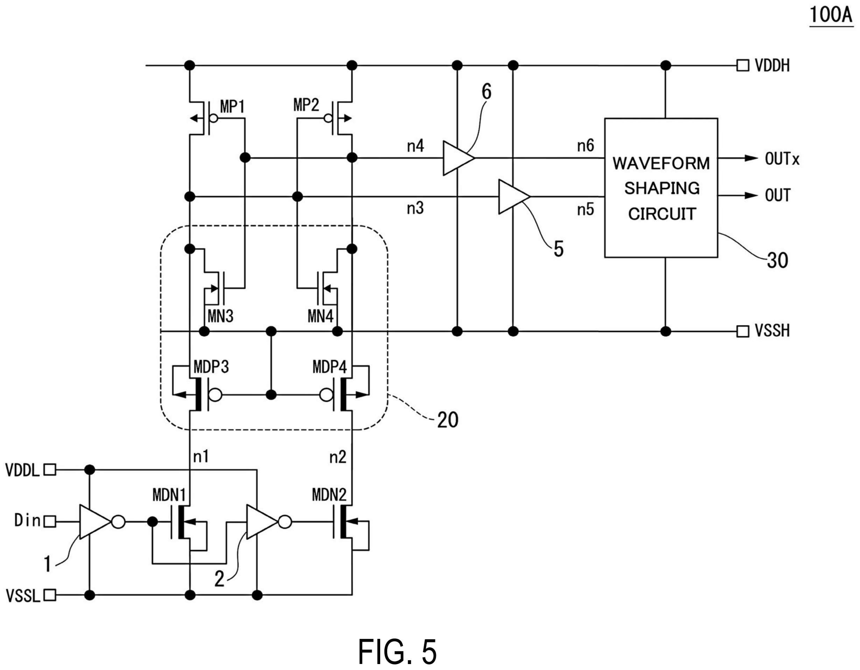

FIG. 5 is a schematic diagram for illustrating a circuit configuration example of a level shift circuit 100A being an example of the level shift circuit according to the modification example.

The level shift circuit 100A is different from the level shift circuit 100 in that the level shift circuit 100A includes a non-inverting circuit 5 and a non-inverting circuit 6 instead of the inverter circuit 3 and the inverter circuit 4, and in that the level shift circuit 100A includes a waveform shaping circuit 30A instead of the waveform shaping circuit 30. The level shift circuit 100A is not substantially different from the level shift circuit 100 in other respects.

Compared to the level shift circuit 100, the level shift circuit 100A is only required to convert the node n3 and the node n4 into logic signals, and is not necessarily required to invert logic levels thereof. The inverter circuit 3 and the non-inverting circuit 5 may be any buffer circuits for providing the node n5 of a logic level corresponding to the voltage value of the node n3. The inverter circuit 4 and the non-inverting circuit 6 may also be buffer circuits. However, whether a buffer circuit connected to the node n3 and a buffer circuit connected to the node n4 are inverter circuits or non-inverting circuits is desired to be unified. An input signal to a latch circuit 50A has a reverse phase relative to an input signal to the latch circuit 50 because the level shift circuit 100A includes the non-inverting circuit 5 and the non-inverting circuit 6 instead of the inverter circuit 3 and the inverter circuit 4.

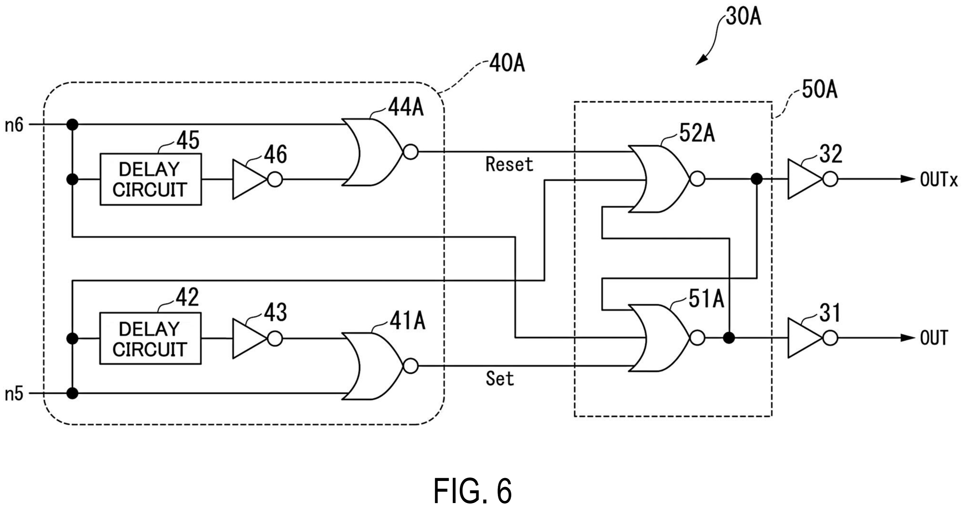

FIG. 6 is a schematic diagram for illustrating a configuration example of the waveform shaping circuit 30A being an example of a waveform shaping circuit in the level shift circuit 100A.

The waveform shaping circuit 30A is different from the waveform shaping circuit 30 in that the waveform shaping circuit 30A includes an edge detection circuit 40A and the latch circuit 50A instead of the edge detection circuit 40 and the latch circuit 50 included in the waveform shaping circuit 30. The waveform shaping circuit 30A is not substantially different from the waveform shaping circuit 30 in other respects.

The edge detection circuit 40A includes a NOR circuit 41A, the delay circuit 42, the inverter circuit 43, a NOR circuit 44A, the delay circuit 45, and the inverter circuit 46. That is, the edge detection circuit 40A includes the NOR circuit 41A and the NOR circuit 44A instead of the NAND circuit 41 and the NAND circuit 44. In the edge detection circuit 40A, the NOR circuit 41A, the delay circuit 42, and the inverter circuit 43 constitute the first edge detection circuit. The NOR circuit 44A, the delay circuit 45, and the inverter circuit 46 constitute the second edge detection circuit.

The first logic signal n5 is directly supplied to a first input terminal of the NOR circuit 41A. Meanwhile, a delayed and inverted first logic signal n5 after passage through the delay circuit 42 and the inverter circuit 43 is supplied to a second input terminal of the NOR circuit 41A. The second logic signal n6 is supplied to the NOR circuit 44A similarly to the NOR circuit 41A. The NOR circuit 41A and the NOR circuit 44A provide a Set signal at a "high" level in a case in which logic levels of the logic signals supplied to both input terminals are at a "low" level. A Set signal at a "low" level is provided in other cases.

For example, during falling of the first logic signal n5, a "high" level that has fallen is supplied to the first input terminal of the NOR circuit 41A. A "low" level obtained by inverting, by the inverter circuit 43, a "high" level present before the falling due to a delay caused by the delay circuit 42 is supplied to the second input terminal of the NOR circuit 41A. A Set signal at a "high" level is provided from an output terminal of the NOR circuit 41A. The NOR circuit 41A provides a Set signal at a "low" level at other timings. The edge detection circuit 40A is different from the edge detection circuit 40 in that the edge detection circuit 40A detects a falling edge by including the NOR circuit 41A instead of the NAND circuit 41.

The latch circuit 50A is desired to have a truth table different from that of the latch circuit 50 because the edge detection circuit 40A provides a signal at a "high" level at a time of detection of a falling edge and provides a signal at a "low" level at a time of no detection. Specifically, the latch circuit 50A is desired to hold a logic level provided immediately before in a case in which the Reset signal and the Set signal are at a "low" level, and cause a logic level to transition in a case in which any one of the Reset signal or the Set signal is at a "high" level. In order to achieve this, the latch circuit 50A includes a connection configuration similar to that of the NAND circuit 51 and the NAND circuit 52, but instead includes a NOR circuit 51A serving as the first logic circuit and the NOR circuit 52A serving as a second logic circuit. That is, the latch circuit 50A includes NOR circuits instead of NAND circuits.

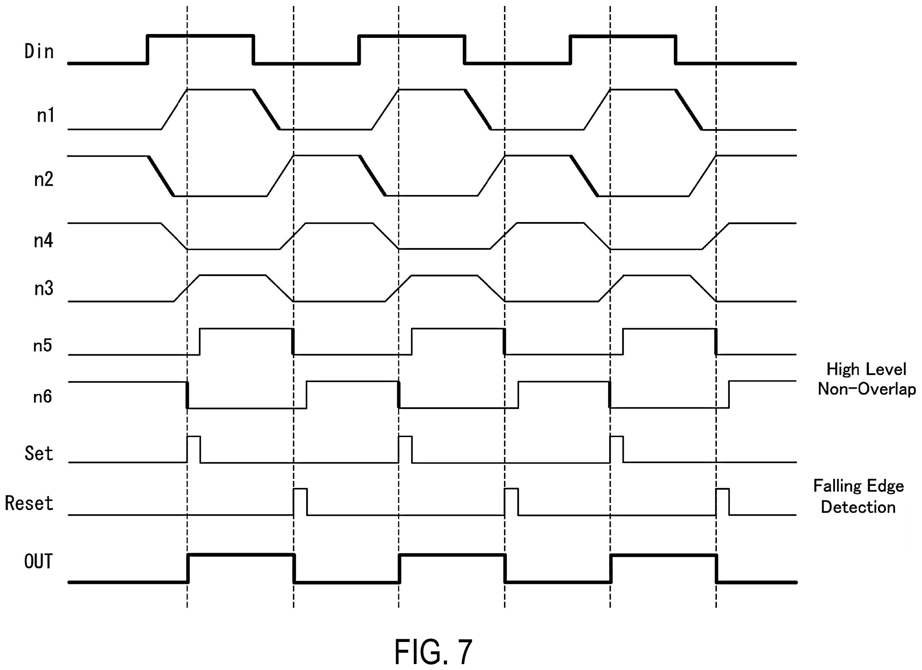

FIG. 7 is a timing chart for illustrating an example of voltage changes at respective positions in the level shift circuit 100A.

The first logic signal n5 and the second logic signal n6 have the same phases as those of the voltage of the node n3 and the voltage of the node n4 because the level shift circuit 100A includes the non-inverting circuit 5 and the non-inverting circuit 6 as components. As a result, a time period for the first logic signal n5 to be at a "high" level and a time period for the second logic signal n6 to be at a "high" level do not overlap ("high"-level non-overlap), thereby enabling avoidance of noise or crosstalk of signals. In addition, as can be understood from FIG. 7, the level shift circuit 100A can reproduce the duty cycle in the same manner as in a case of detecting a rising edge by setting a falling edge as an inversion timing of a logic level of the output logic signal OUT.

### [Second Embodiment]

A level shift circuit according to a second embodiment of the present invention is a level shift circuit for shifting a logic level from a logic level of a high-voltage region to a logic level of a low-voltage region. In addition, a level shifter according to the second embodiment includes a plurality of stages each including the level shift circuit according to the second embodiment, the plurality of stages being connected in series.

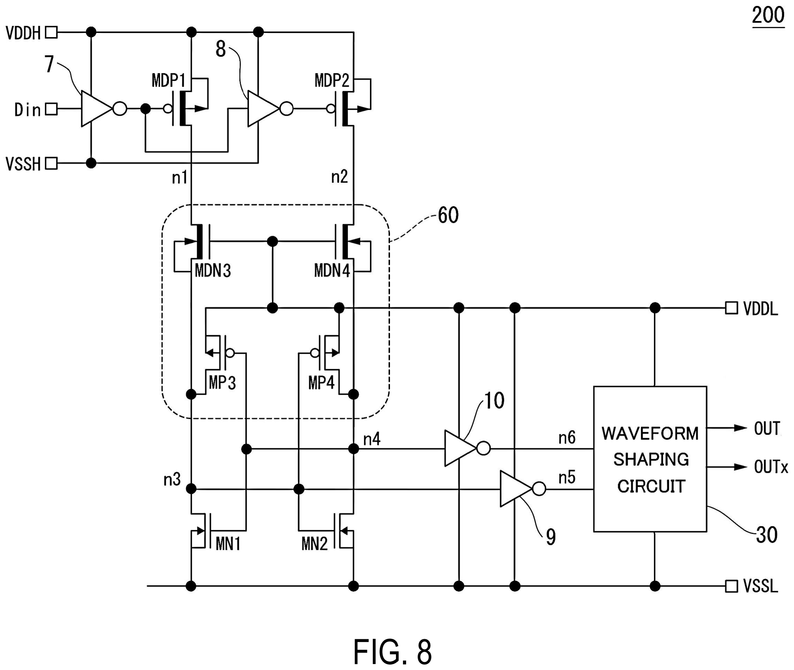

FIG. 8 is a schematic diagram for illustrating a circuit configuration example of a level shift circuit 200 being an example of the level shift circuit according to the second embodiment.

At the logic level on the high-voltage side, a "low" level voltage is set as the voltage VSSH serving as the second voltage, and a "high" level voltage is set as the voltage VDDH serving as the first voltage. At the logic level on the low-voltage side, a "low" level voltage is set as the voltage VSSL serving as the fourth voltage. A "high" level voltage is set as the voltage VDDL serving as the third voltage.

The level shift circuit 200 includes an inverter circuit 7, an inverter circuit 8, an inverter circuit 9, an inverter circuit 10, a transistor MDP1, a transistor MDP2, a transistor MN1, a transistor MN2, a clamp circuit 60, and the waveform shaping circuit 30. The level shift circuit 200 illustrated as an example in FIG. 8 detects, for example, a falling edge.

The input logic signal Din is supplied to an input terminal of the inverter circuit 7. An output terminal of the inverter circuit 7 is connected to a gate of the transistor MDP1 and the inverter circuit 8. An input terminal of the inverter circuit 8 is connected to the output terminal of the inverter circuit 7. An output terminal of the inverter circuit 8 is connected to a gate of the transistor MDP2.

The transistor MDP1 serving as the first transistor has the gate connected to the output terminal of the inverter circuit 7, a source connected to the voltage VDDH, and a drain connected to the clamp circuit 60. The input logic signal Din having a reverse phase after passage through the inverter circuit 7 is supplied to the gate of the transistor MDP1. The drain of the transistor MDP1 is connected to a drain of the transistor MN1 through the clamp circuit 60.

The transistor MDP2 serving as the second transistor has the gate connected to the output terminal of the inverter circuit 8, a source connected to the voltage VDDH, and a drain connected to the clamp circuit 60. The input logic signal Din having a positive phase after passage through the inverter circuit 7 and the inverter circuit 8 is supplied to the gate of the transistor MDP2. The drain of the transistor MDP2 is connected to a drain of the transistor MN2 through the clamp circuit 60.

In the following description, a connection between the drain of the transistor MDP1 and the clamp circuit 60 is sometimes referred to as "node n1." A connection between the drain of the transistor MDP2 and the clamp circuit 60 is sometimes referred to as "node n2."

The transistor MN1 serving as the third transistor has a gate and the drain connected to the clamp circuit 60, and a source connected to the voltage VSSL. Further, similarly to the transistor MN1, the transistor MN2 serving as the fourth transistor has a gate and the drain connected to the clamp circuit 60, and a source connected to the voltage VSSL.

The clamp circuit 60 is connected to the drains of the transistor MDP1 and the transistor MDP2 on a high-voltage side. The clamp circuit 60 is also connected to the drains and the gates of the transistor MN1 and the transistor MN2 on a low-voltage side. In the following description, a connection between the gate of the transistor MN2 and the clamp circuit 60 is sometimes referred to as "node n3." Further, a connection between the gate of the transistor MN1 and the clamp circuit 60 is sometimes referred to as "node n4." The node n3 and the node n4 are output terminals of the clamp circuit 60, and are not limited to an example of connections to the gates.

The drains of the transistor MDP1 and the transistor MN1 are connected to each other through the clamp circuit 60. Accordingly, in a case in which the transistor MN1 is off and the transistor MDP1 is on, a voltage on the drain side of the transistor MN1 is pulled toward the voltage VDDH to which the source of the transistor MDP1 is connected. Meanwhile, in a case in which the transistor MDP1 is off and the transistor MN1 is on, the voltage on the drain side of the transistor MN1 is pulled toward the voltage VSSL to which the source of the transistor MN1 is connected. The transistor MDP2 and the transistor MN2 also have a relationship similar to the relationship between the transistor MDP1 and the transistor MN1.

The clamp circuit 60 limits voltages of the node n3 and the node n4 to stay within a range from the voltage VSSL to the voltage VDDL serving as the low-voltage region. More specifically, the clamp circuit 60 prevents the voltages of the node n3 and the node n4 from becoming larger than the voltage VDDL at the "high" level in the low-voltage region. The clamp circuit 60 also controls on/off states of the transistor MN1 and the transistor MN2 by controlling the gates of the transistor MN1 and the transistor MN2 in accordance with on/off states of the transistor MDP1 and the transistor MDP2.

An input terminal of the inverter circuit 9 is connected to the node n3. An output terminal of the inverter circuit 9 is connected to the waveform shaping circuit 30. Further, an input terminal of the inverter circuit 10 is connected to the node n4. An output terminal of the inverter circuit 10 is connected to the waveform shaping circuit 30. That is, a first logic signal corresponding to a voltage value of the node n3 and a second logic signal corresponding to a voltage value of the node n4 are supplied to the waveform shaping circuit 30. In the following description, a connection between the output terminal of the inverter circuit 9 and the waveform shaping circuit 30 is referred to as "node n5." The first logic signal is sometimes denoted by a reference symbol "n5." Further, a connection between the output terminal of the inverter circuit 10 and the waveform shaping circuit 30 is referred to as "node n6." The second logic signal is sometimes denoted by a reference symbol "n6."

The waveform shaping circuit 30 shapes a waveform by inverting logic levels of the output logic signal OUT and the output logic signal OUTx based on the supplied first logic signal n5 and the supplied second logic signal n6. The processing and the circuit configuration of the waveform shaping circuit 30 are similar to those of the first embodiment. Although not shown, processing and a circuit configuration similar to those of the waveform shaping circuit 30A may be used.

A configuration example of the clamp circuit 60 is described next. The clamp circuit 60 includes a transistor MDN3, a transistor MDN4, a transistor MP3, and a transistor MP4. The circuit configuration of the clamp circuit 60 illustrated as an example in FIG. 8 is an example of implementation of the clamp circuit 60. The second embodiment is not limited to this example.

The transistor MDN3 serving as the fifth transistor has a gate supplied with the voltage VDDL, a source connected to the node n3, and a drain connected to the node n1. Further, the transistor MDN4 serving as the sixth transistor has a gate supplied with the voltage VDDL, a source connected to the node n4, and a drain connected to the node n2. The transistor MDN3, by having the gate supplied with the voltage VDDL at the "high" level in the low-voltage region, is turned off in a case in which a source voltage (node n3) is about to exceed the voltage VDDL, and thereby cuts off a connection to the voltage VDDH through the transistor MDP1. As a result, the node n3 is prevented from further rising in voltage, and is thereby clamped within the range of the low-voltage region. The transistor MDN4 also functions similarly to the transistor MDN3 in clamping the node n4.

The transistor MP3 serving as the seventh transistor has a gate connected to the node n4, a source connected to the voltage VDDL, and a drain connected to the node n3. Further, the transistor MP4 serving as the eighth transistor has a gate connected to the node n3, a source connected to the voltage VDDL, and a drain connected to the node n4. The node n3 can stably provide the "high" level (voltage VDDL) in the low-voltage region by the transistor MP3 being turned on to connect the voltage VDDL and the node n3 in a case of providing the "high" level from the node n3. The transistor MP4 also functions similarly to the transistor MP3 in a case of providing the "high" level from the node n4.

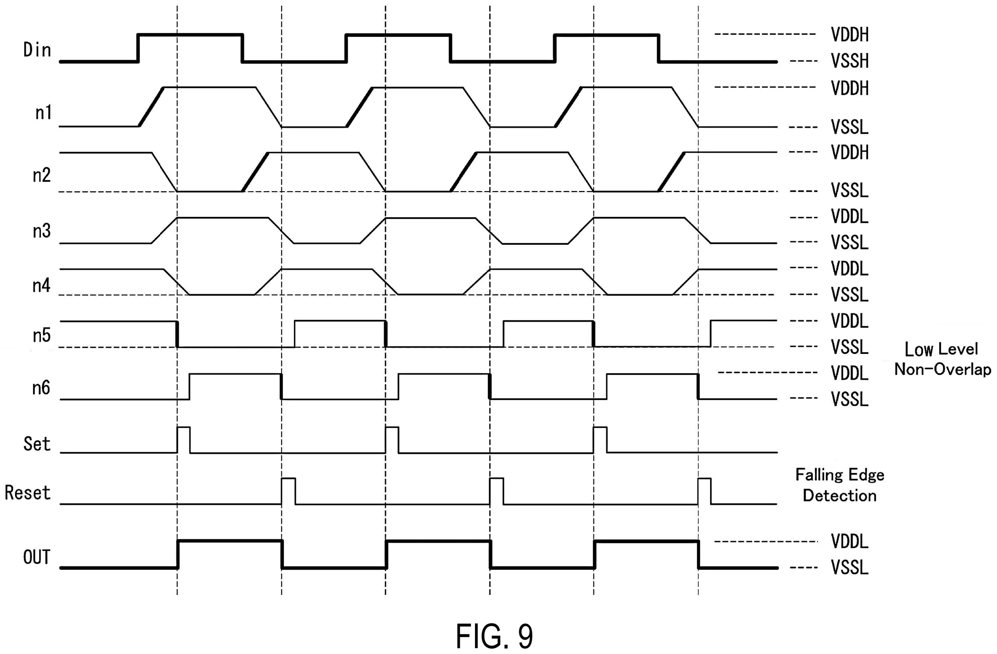

FIG. 9 is a timing chart for illustrating an example of voltage changes at respective positions in the level shift circuit 200 according to the second embodiment. The level shift circuit 200 operates similarly to the level shift circuit according to the first embodiment (including the modification example) such as the level shift circuit 100. Description of common points may be omitted.

In the case in which the input logic signal Din rises, the transistor MDP1 having the gate receiving a reverse-phase signal is turned on, and the transistor MDP2 having the gate receiving a positive-phase signal is turned off. The node n1 is connected to the voltage VDDH at the "high" level in the high-voltage region and a voltage value rises by the transistor MDP1 being turned on. In contrast, even in a case in which the transistor MDP2 is turned off, the voltage value of the node n2 does not fall because the transistor MN2 connected to the voltage VSSL at the "low" level in the low-voltage region is off. The node n2 is connected to the voltage VSSL and the voltage value starts to fall because a voltage value of a gate input of the transistor MN2 rises following the rising in the voltage value of the node n1 and the transistor MN2 is turned on.

The voltage value of the node n3 rises following the rising in the voltage value of the node n1 and is clamped at the voltage VDDL by the clamp circuit 60. The voltage value of the node n4 falls to the voltage VSSL because the transistor MN2 becomes connected to the voltage VSSL. The voltage value of the node n3 stays at the voltage VDDL without falling because the voltage value of the node n4 falls and the transistor MN1 is thereby turned off. The voltage value of the node n4 also stays at the voltage VSSL without rising because the transistor MDP2 is off.

In the case in which the input logic signal Din falls, operations at the node n1 and the node n2 and operations at the node n3 and the node n4 are respectively inverted relative to the operations in the above-mentioned case in which the input logic signal Din rises. After that, the level shift circuit 200 causes the waveform shaping circuit 30 to shape the output logic signal OUT so as to reproduce the duty cycle of the input logic signal Din.

As described above, with the level shift circuit according to the at least one embodiment (including the modification example; the same applies hereinafter), it is possible to shape a waveform so as to have a duty cycle substantially equal to the duty cycle of the input logic signal Din before the waveform becomes completely distorted by providing at least one of the waveform shaping circuit 30 or the waveform shaping circuit 30A. That is, it is possible to suppress occurrence of duty cycle deviation between the input logic signal Din and the output logic signal OUT, the deviation being caused in related-art level shift circuits by response times for raising a voltage of a logic level of a low-voltage region to a logic level of a high-voltage region or response times for lowering a voltage of a logic level of a high-voltage region to a logic level of a low-voltage region. In addition, with the level shift circuit according to the at least one embodiment, application to both level shifting to a high voltage and level shifting to a low voltage is possible.

The level shift circuit according to the at least one embodiment may constitute a level shifter through connection in series of a plurality of stages each including the level shift circuit. With the level shifter according to the at least one embodiment, duty cycle deviation of each stage is negligibly small. As a result, a total amount of deviation accumulating in a case in which a plurality of stages of level shift circuits are connected becomes small. Thus, pulse deviation, pulse disappearance, or the like can be prevented.

With the level shift circuit according to the at least one embodiment, a time from a transition of the input logic signal Din to the rising of the voltage of the node n6 and a time from a transition of the input logic signal Din to the rising of the voltage of the node n5 are substantially identical because the respective circuits in the level shift circuit operate symmetrically during rising and falling of the input logic signal Din. A period of a voltage change of the node n5 and a period of a voltage change of the node n6 are also substantially identical. Accordingly, the duty cycle of the input logic signal Din is reproducible based on a time difference between the node n5 and the node n6.

The level shift circuit according to the at least one embodiment can provide the output logic signal OUT accurately reproducing the duty cycle of the input logic signal Din by causing a logic level to transition based on a timing relatively facilitating identification of a rising edge or a falling edge. Accordingly, it is possible to prevent pulse disappearance or the like in a case in which a plurality of stages each including the level shift circuit according to the at least one embodiment are connected.

An RS latch has been illustrated as an example of a latch circuit in the level shift circuit according to the at least one embodiment. In the latch circuit illustrated as an example, the first logic signal n5 and the second logic signal n6 are bypassed in addition to the Set signal, the Reset signal, and feedback between respective logic circuits. The RS latch circuit may have an indeterminate output state depending on logic levels of input signals. For example, there is a possibility that the output state becomes indeterminate immediately after starting the level shift circuit. In a case of a mere oscillator, an indeterminate state for a moment does not easily become a major problem. However, in use for an application or the like, an indeterminate state may cause a malfunction. The latch circuit illustrated as an example and applied to the level shift circuit according to the at least one embodiment is more suitable for application use because an indeterminate state is avoidable by bypassing the first logic signal n5 and the second logic signal n6.

The above-mentioned configuration can also address the problem of a large area of related-art configurations (as disclosed in, for example, Japanese Patent Application Laid-open No. 2021-52393), the problem being potentially inherent in circuit inventions. More specifically, a related-art level shift circuit includes a clamp circuit including a power transistor having a large occupied area. Thus, a total area of the clamp circuit and a circuit including the clamp circuit is also large. In contrast, with the clamp circuit applied in the at least one embodiment, it is possible to reduce the number of circuit elements included in a clamp circuit to a lower level than in the related-art configuration.

For example, compared to the clamp circuit of the latch-based high-voltage level shifter circuit as disclosed in Japanese Patent Application Laid-open No. 2021-52393, it is possible to reduce two transistors having high breakdown voltages relative to general transistors. The reducible circuit elements are transistors (power transistors) having high breakdown voltages with occupied areas relatively larger than general transistors. It is thus possible to fabricate a smaller clamp circuit and an IC including the clamp circuit. Application of the above-mentioned clamp circuit is not limited to the level shifter circuit according to the at least one embodiment, and the clamp circuit can be applied to various circuits requiring voltage clamping.

The at least one embodiment of the present invention has been described above with reference to the drawings, and each component described in the at least one embodiment is an example corresponding to each matter to define the invention in the appended claims. That is, a specific configuration of each component described in the at least one embodiment is not limited to the one described above. Various changes or improvements, configurations easily conceived of by a person skilled in the art, or substantially identical configurations are included. The above-mentioned components may be combined appropriately. In short, various omissions, substitutions, or changes of components may be made to the at least one embodiment within the scope that does not depart from the gist of the present invention.

In configuring the level shifter 110, the waveform shaping circuit 30 may be omitted within a range enabling waveform shaping by the waveform shaping circuit 30 before the waveform becomes completely distorted, for example, setting the level shift circuit 100 without the waveform shaping circuit 30 in a first stage and setting the level shift circuit 100 including the waveform shaping circuit 30 in a second stage. That is, the level shifter 110 may partially include the level shift circuit 100 with the waveform shaping circuit 30 omitted. Those embodiments and the modification example are included in the scope and the gist of the invention, and are also included in the invention described in the appended claims and the scope of equivalents thereof.

## Claims

1. A level shift circuit (100, 100A, 200) for shifting a level of an input logic signal indicating logic levels with a first voltage and a second voltage into an output logic signal indicating logic levels with a third voltage and a fourth voltage, the level shift circuit comprising:
a first transistor (MDN1, MDP1) including a gate supplied with a reverse-phase signal of the input logic signal, a source connected to the first voltage, and a drain connected to a clamp circuit (20,60);
a second transistor (MDN2, MDP2) including a gate supplied with a positive-phase signal of the input logic signal, a source connected to the first voltage, and a drain connected to the clamp circuit;
a third transistor (MP1, MN1) including a source connected to the fourth voltage and a drain connected to the clamp circuit;
a fourth transistor (MP2, MN2) including a source connected to the fourth voltage and a drain connected to the clamp circuit;
the clamp circuit connected to a first node (n3) and a second node (n4) and configured to limit voltages of the first node and the second node within a range from the third voltage to the fourth voltage;
a first buffer circuit (3, 5, 9) configured to receive the voltage of the first node and provide a first logic signal corresponding to the voltage of the first node;
a second buffer (4, 6, 10) circuit configured to receive the voltage of the second node and provide a second logic signal corresponding to the voltage of the second node; and
a waveform shaping circuit (30) configured to receive the first logic signal and the second logic signal and provide the output logic signal based on level transitions of the first logic signal and the second logic signal in the same direction,
in which, of a pair of the first transistor and the second transistor and a pair of the third transistor and the fourth transistor, the pair connected to a high-voltage side are of a first conductivity type being one of a P-type or an N-type, and the pair connected to a low-voltage side are of a second conductivity type being another one of the P-type or the N-type.

2. The level shift circuit (100, 100A, 200) according to claim 1, wherein the waveform shaping circuit includes:
an edge detection circuit (40, 40A) configured to receive the first logic signal and the second logic signal and detect one of a rising edge or a falling edge of the received logic signals; and
a latch circuit (50, 50A) configured to provide the output logic signal shaped by causing a logic level to transition in a case of detection by the edge detection circuit.

3. The level shift circuit (100, 100A, 200) according to claim 2,
wherein the edge detection circuit includes:
a first edge detection circuit configured to provide a first detection signal indicating whether an edge of the first logic signal has been detected; and
a second edge detection circuit configured to provide a second detection signal indicating whether an edge of the second logic signal has been detected,
wherein the latch circuit includes a first logic circuit (51) and a second logic circuit (52),
wherein the first detection signal, the second logic signal, and an output signal of the second logic circuit are supplied to the first logic circuit, and
wherein the second detection signal, the first logic signal, and an output signal of the first logic circuit are supplied to the second logic circuit.

4. The level shift circuit (100, 100A, 200) according to claim 1,
wherein the drain of the third transistor is connected to the first node,
wherein the drain of the fourth transistor is connected to the second node,
wherein the clamp circuit includes:
a fifth transistor (MDN3, MDP3) including a gate supplied with the third voltage, a drain connected to the drain of the first transistor, and a source connected to the first node;
a sixth transistor (MDN4, MDP4) including a gate supplied with the third voltage, a drain connected to the drain of the second transistor, and a source connected to the second node;
a seventh transistor (MP3, MN3) including a gate connected to the second node, a source connected to the third voltage, and a drain connected to the first node; and
an eighth transistor (MP4, MN4) including a gate connected to the first node, a source connected to the third voltage, and a drain connected to the second node, and
wherein, of a pair of the fifth transistor and the sixth transistor and a pair of the seventh transistor and the eighth transistor, the pair connected to a low-voltage side are of the first conductivity type, and the pair connected to a high-voltage side are of the second conductivity type.

5. The level shift circuit (100, 100A, 200) according to any one of claims 1 to 4, wherein a voltage region from the third voltage to the fourth voltage is lower in voltage than a voltage region from the first voltage to the second voltage.

6. A level shifter (110) comprising a plurality of stages each including the level shift circuit (100, 100A, 200) of any one of claims 1 to 5, the stages being connected in series.
